## Europäisches Patentamt

## European Patent Office

## Office européen des brevets

(11) Publication number: **0 249 366**
**B1**

(12) **EUROPEAN PATENT SPECIFICATION**

(45) Date of publication of patent specification: **06.02.91**

(51) Int. Cl.⁵: **B 22 F 9/24**

(21) Application number: **87304772.4**

(22) Date of filing: **29.05.87**

(54) **Process for the production of silver-palladium alloy fine powder.**

<table>
<tr><td>

(30) Priority: **30.05.86 JP 125495/86**

(43) Date of publication of application:
**16.12.87 Bulletin 87/51**

(45) Publication of the grant of the patent:
**06.02.91 Bulletin 91/06**

(84) Designated Contracting States:
**DE FR GB**

(56) References cited:
**FR-A-1 382 667**
**FR-A-2 131 683**
**FR-E- 91 096**
**GB-A-1 004 652**
**US-A-3 390 981**
**US-A-3 620 713**

**Metals Handbook, vol. 7 (9th edition), Powder Metallurgy, pages 147-151, 1984, American Society for Metals, OHIO, USA**

</td><td>

(73) Proprietor: **MITSUI MINING & SMELTING CO., LTD.**
**1-1, Muromachi 2-chome Nihonbashi, Chuo-ku Tokyo 103 (JP)**

(72) Inventor: **Hayashi, Takao**
**No. 6-25, Hikoshima-Sakomachi 6-chome Shimonoseki-shi Yamaguchi-ken (JP)**
Inventor: **Ushijima, Akio**
**No. 8-2, Hikoshima-Nishiyamacho 2-chome Shimonoseki-shi Yamaguchi-ken (JP)**
Inventor: **Nakamura, Yoshinobu**
**No. 1343-14, Yasuokashinmachi Shimonoseki-shi Yamaguchi-ken (JP)**

(74) Representative: **Perry, Robert Edward et al**
**GILL JENNINGS & EVERY 53-64 Chancery Lane London WC2A 1HN (GB)**

</td></tr>
</table>

# EP 0 249 366 B1

**Description**

Background of the Invention

1. Field of the invention

The present invention relates to a process for the production of a silver-palladium alloy fine powder that is used for the production of electrode materials, contacts or the like used in the electronic industries field, in particular for the production of ceramic capacitors or the like.

2. Description of the Prior Art

In the electronic industries field, silver-palladium pastes have been widely used for thick film conductive circuits employed in screen printing. The objects of using silver-palladium are to repress the migration occurring when wiring is made by the use of silver alone, to raise the melting point of silver by adding palladium so that the conditions for using substrates at desired temperatures are applicable, and the like.

In recent years, with the small size and precision of electronic parts, there are growing demands for decreasing the thickness of conductive films to several microns and further narrowing the width of and between wiring circuits (to, for instance, 100 microns; 1 micron = 1 μm). To meet such demands, it is required that the conductive metal powder constituting the paste should have a small particle diameter, an even grain size and a uniform composition.

In contrast with this, the fact is that the silver-palladium paste has usually been used in the manner of mixing separately manufactured silver powder and palladium powder for a very long period of time until a mutual uniform dispersion is achieved.

This process has the disadvantages that a very long time, for instance, several tens of hours, is needed for dispersion, and microscopic structure of a mixture is inevitably heterogeneous.

Accordingly, the demands for such electronic parts cannot be fully satisfied.

In addition, the use of a conventional Ag-Pd mixture for the inner electrode of the ceramic capacitors has disadvantages, e.g. that delamination is very likely to occur between the electrode and the ceramic, and that the capacity of the capacitor is likely to be reduced. This is because the mixed powder undergoes abnormal expansion and shrinkage in the alloy formation, during firing, and at temperatures before the ceramic is fired and its strength increased, i.e. 100—500°C. This tendency is more violent for dielectrics of reduced film thickness.

In order to solve these problems, it has been proposed to use an Ag-Pd alloy powder. See, for instance, JP-A-11701/1983, JP-A-132503/1984 and JP-A-224111/1984. The powder manufacturing process is disclosed in JP-A-56125/1978.

The given prior art processes for the production of Ag-Pd alloy powder all comprise heat-reducing a mixed oxide or mixed hydroxide of silver and palladium in a stream of hydrogen or, in the case of JP-A-224111/1984, heating an intimate mixture of silver and palladium powders at 300°C in air.

However, these processes are not commercially satisfactory, since precursors to be alloyed, namely oxide, hydroxide or two kinds of metal powders, and a dangerous gas (hydrogen), are required. Further, heating to high temperatures in air is not desirable, because particles are mutually sintered, and Ag and Pd are oxidised. In addition, these prior art processes have the disadvantage that the resultant powder is partially alloyed but coexists with Ag and Pd powders, so that delamination cannot be prevented completely.

GB-A-1004652 discloses a process for the production of Pd-Ag alloys. A nitric acid solution of Pd and Ag is prepared, the Pd and Ag being present therein in the ratio desired in the resulting alloy which is precipitated in finely divided form by mixing the acidic solution with a reducing agent that will simultaneously reduce both of the dissolved metal nitrates to metal. The resulting Pd-Ag alloy has an average particle size of 0.1—0.5 μm. A mixture of hydrazine sulfate and hypophosphorous acid may be used as the reducing agent.

Metals Handbook, Volume 7, Powder Metallurgy, pages 147—151; 9th edition, 1984, American Society for Metals, Ohio, USA, discloses the production of precious metal powders, and refers to GB-A-1004652 and also to US-A-3390981. The latter prior art document also discloses that the physical properties of the resulting powder can be modified by the same techniques as are used to modify platinum powder, i.e. by heat-treating the powder under controlled conditions to reduce the surface area of the powders, or by a galvanic precipitation process of Pt with Zn dust, such that no additional heat treatment of the resulting powder is necessary.

Summary of the Invention

It is an object of the present invention to eliminate the given problems, and to provide a process that is capable of manufacturing, by a simple wet process, a fine powder of a silver-palladium alloy whose composition may be easily controlled, which is free from delamination when used as the inner electrode of a ceramic capacitor and which can profitably be used in the electronic industry.

According to the present invention, a silver-palladium alloy is formed by a process which comprises adding hydrazine or a hydrazine compound to an acidic solution containing silver and palladium as ions,

2

and reducing the ions; separating a silver-palladium alloy fine powder, having an average particle diameter of 0.01—1.0 μm formed by reduction; and heat-treating the alloy fine powder at a temperature of 100-500°C in an inert atmosphere or vacuum.

Detailed Description of the Invention

The process of the present invention employs a solution in which Ag ions and pd ions coexist. The source of Ag ions is an aqueous solution containing Ag as ions, preferably an aqueous silver nitrate solution. The source of Pd ions may be any solution which contains Pd as ions, preferably an aqueous palladium nitrate solution. A palladium chloride solution is not preferred, because chloride ions react with silver ions, and silver chloride precipitates out: the silver ions are prevented from being used effectively, and the final product is in danger of containing chlorine which has an undesirable influence on wiring circuit material.

The aqueous silver nitrate solution and aqueous palladium nitrate solution are mixed into an acidic, preferably nitric acid, solution. The "acidic solution" is indispensable for the production of an Ag-Pd alloy fine powder. The preferred Ag and Pd ion concentrations in the mixed solution are 10—200 g/l in sum total. The concentration ratio of silver to palladium can be selected according to the composition of the finally produced silver-palladium alloy fine powder. That is, the composition ratio of the silver-palladium alloy fine powder of the present invention can be controlled readily by changing the concentration ratio of the mixed solution of the starting substance, namely said mixed solution of silver and palladium.

As the result of this, not only the alloy powder suitable for the paste for use in the silver-palladium thick film conductive circuit containing several % several — tens % of palladium having been used industrially but also the silver-palladium alloy fine powder having an extremely wide range of palladium contents can be produced.

Next, a hydrazine compound is added to the mixed acidic solution of silver and palladium for reduction separating silver ions and palladium ions in the form of fine powder. Further, the composition of said alloy powder is determined by migration of the concentration ratio of the mixed solution as it is to the separated powder. The utility of the present invention consists herein.

The amount of the hydrazine compound added is suitably 2—10 times the equivalent required for reduction of silver ions and palladium ions contained in said silver-palladium mixed solution. In case said amount is less than 2 times, the reduction is insufficient or the reducing reaction takes a long period of time. In case said amount is more than 10 times, it incurs a loss of superfluous hydrazine compound.

As the hydrazine compound to be used as the reducing agent there may be used any compound that contains hydrazine as a component and is able to reduce in the same action as that of hydrazine. In particular, hydrazine hydrate is preferable.

The temperature of the reducing solution is preferably in the range of 10—100°C. In case said temperature is lower than said range, there is such a tendency that the reaction is delayed and further the composition of the alloy fine powder to be obtained is not homogenized, whilst in case said temperature is higher than 100°C, the operation becomes difficult because the solution may boil.

In order to accelerate the reaction, there may be used a usual way such as stirring or the like so that the hydrazine compound may react effectively with the whole amount of silver ions and palladium ions contained in the solution. The reaction is continued until bubbles caused with the progress of reaction disappear and no more change is observed.

Next, the solution containing reduction-separated silver-palladium alloy fine powders in the slurry state may be subjected to solid-liquid separation in a usual manner so as to separate and recover said fine powders from said solution. The usual manner referred to herein may be any prior art manner such as gravitational sedimentation, reduced-pressure filtration, centrifugal separation, pressure filtration or the like.

Next, the solid-liquid separated and wet fine powders may also be subjected to after-treatment in a usual manner. In other words, said fine powders are washed with water to remove the solution component attached onto said fine powders. Then, prior to drying, the fine powders may be washed with a low boiling solvent, thereby replacement removing the water attached onto the fine powders. In this case a hydroxyl group-free solvent such as acetone is used as the low boiling solvent. A hydroxyl group-containing solvent is not profitable in that said solvent will not operative effectively and further not preferable from the viewpoint of safety operation because said solution is subjected to spontaneous combustion by catalysis of the silver-palladium fine powder.

Next, the separation-recovered alloy fine powder with the low boiling solvent attached thereon is dried to thereby remove the low boiling solvent by volatilization. The atmosphere under which drying is conducted may be any one of air, inert gas and vacuum, but normally it is preferable to conduct drying in limit air. The drying temperature is not specifically limited. When drying is conducted in air; it may be conducted at temperatures in the range of room temperature to about 90°C.

The obtained silver-palladium alloy fine powder may then be heat-treated at temperatures of 100—500°C in an inert atmosphere or vacuum. Owing to this heat-treatment, the surface area of the silver-palladium alloy fine powder is decreased, and simultaneously the silver-palladium alloy fine powder is more uniform in structure. In this connection, it is to be noted that in case this heat-treating temperature is less than 100°C, the effect of said heat-treatment is not sufficient. Even when said heat-treating temperature is in

EP 0 249 366 B1

excess of 500°C, in contrast, there can not be seen any development of the surface area and the structural uniformed state. This heat-treatment may be performed on the water soluble liquid slurry per se from which the alloy fine powder is formed, or may be performed on the drying-recovered fine powder using any one of dry and wet methods.

The specific surface area of the silver-palladium alloy fine powder before the heat-treatment is 5—30 $m^2/g$. One example thereof, although varying depending on the factors such as the manufacturing conditions, particle diameter, powder composition and the like, is shown in Table-1. The results obtained from the silver-palladium alloy fine powder after the heat-treatment is shown in Table-2. It can be seen from Table-2 that the heat-treatment makes fine roughness of the surface smooth and thus reduces the specific surface area. In addition, the structure state of alloy is also unified by the heat-treatment, which will be referred to afterwards.

As aforesaid, the heat-treatment functions to reduce the specific surface area. This fact means that, when using the alloy powder as paint or paste material, the reduced specific surface area can prevent the occurrence of increased oil absorption, lowered oxidation resistance and other inconveniences caused in case the surface area is large.

4

## Table - 1

| Sample | Pd composition (wt.%) | Specific surface area ($m^2$/g) | Average particle diameter ($\mu$m) * |
|--------|----------------------|--------------------------------|--------------------------------------|
| A | 20 | 13.1 | 0.2 |
| B | 30 | 20.0 | 0.2 |

* The average particle diameter is a value measured from an electron microscope photo

## Table - 2

| Sample | Pd composition (wt.%) | Specific surface area before heat-treatment ($m^2$/g) | Heat-treating atmosphere | Specific surface area after heat-treatment ($m^2$/g) | |
|--------|--------|--------|--------|--------|--------|
| | | | | 100°C | 200°C |
| A | 20 | 13.1 | Air | 10.5 | 8.0 |
| | | | Nitrogen | 8.0 | 4.5 |
| B | 30 | 20.0 | Air | 10.5 | 6.5 |
| | | | Nitrogen | 9.5 | 4.5 |

EP 0 249 366 B1

The state of alloying will be explained from the analytical results obtained by X-ray diffraction hereinafter.

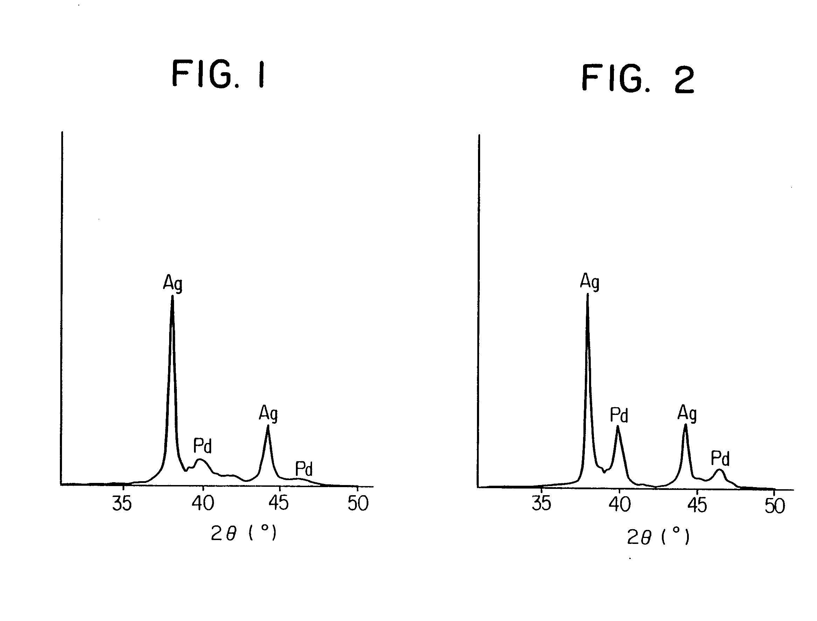

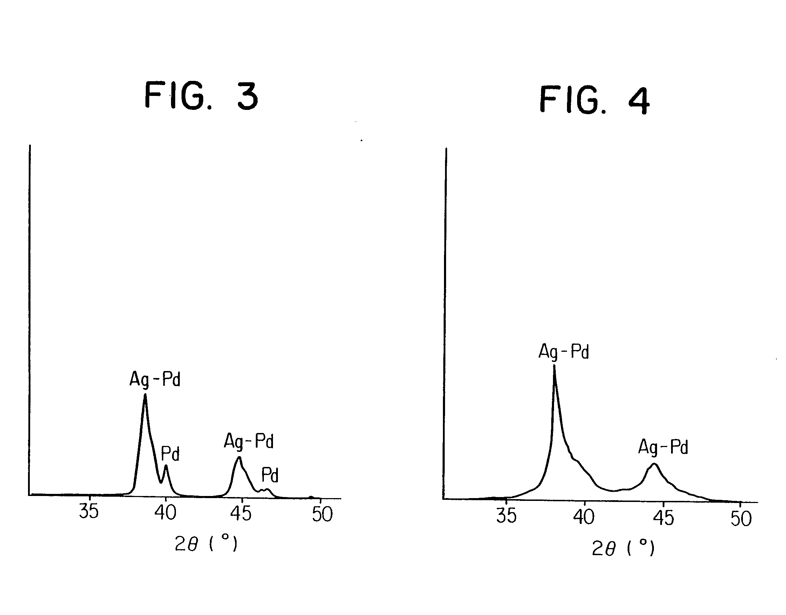

Fig. 1 to Fig. 3 illustrate comparative examples, and Fig. 4 to Fig. 6 illustrate data pertaining to the present invention.

Fig. 1 is an X-ray diffraction view of a 30 wt.% palladium-containing silver-palladium mixed powder obtained by well mixing a commercially available silver powder (0.2 micron) and palladium powder (0.1 micron) for a long period of time. It can be seen therefrom that silver and palladium each has its own peak and is in a mere mixed state.

Fig. 2 illustrates said mixed powder heat-treated at 200°C and for 60 minutes in nitrogen, and Fig. 3 illustrates said mixed powder heat-treated at 400°C and for 60 minutes in nitrogen. It can be seen therefrom that when treated at 200°C, no change is observed in the mixed state, and that when treated at 400°C, the mixed powder is observed to be partially alloyed for the first time but still contain palladium in the form of a simple substance.

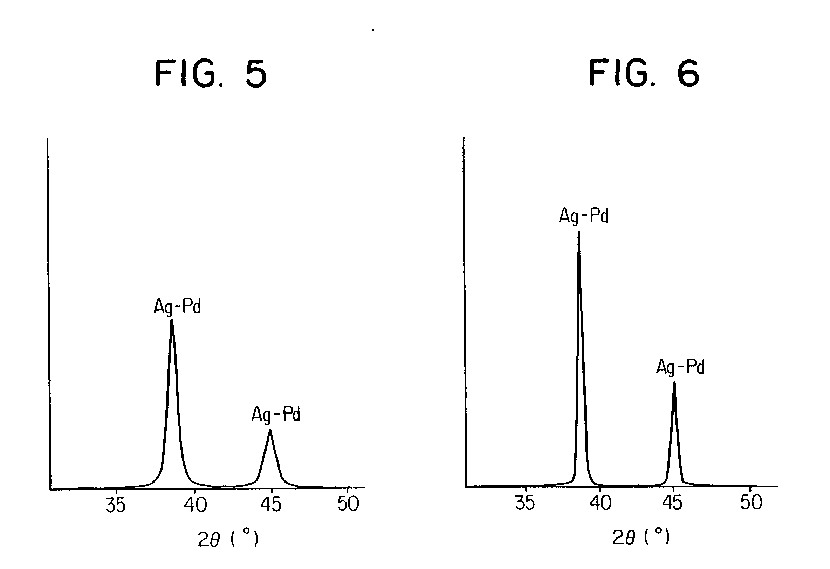

Fig. 4 is an X-ray diffraction view of a 30 wt.% palladium-containing silver-palladium alloy fine powder (average particle diameter 0.2 micron) prepared according to the process of the present invention. Fig. 5 and Fig. 6 are X-ray diffraction views of said alloy fine powder treated at 200°C and for 60 minutes in nitrogen and treated at 400°C and for 60 minutes in nitrogen respectively.

It can be seen therefrom that the powder according to the process of the present invention has already been alloyed in contrast with the case of said mixed powder. Fig. 6 illustrates the case where the solids have dissolved completely, thereby causing particle growth and more unified structure.

The mechanism wherein the silver-palladium alloy powder is obtained by the aforesaid process of the present invention is not always clarified, but is considered to consist in that to begin with, nuclei are formed, grown silver-palladium ultrafine particles (several tens Å) cohere and contact mutually, and said particles diffuse and fuse together for alloying.

The present invention as mentioned above is advantageous in that silver or palladium powder-free alloyed silver-palladium fine powders are obtained, in that by treating said powders at industrially handy temperatures of 100—500°C there can be obtained fine powders whose specific surface area has been greatly reduced and whose alloying state has been more improved; in case said fine powders are used for inner electrodes in ceramic capacitors, the occurrence of delamination can be prevented completely; said particles can be suitably used also in the other electronic industries fields; and that such silver-palladium alloy fine powders can be prepared by a simple wet process and apparatus which are free from the use of hydrogen.

According to the present invention, furthermore, little Ag diffuses in a dielectric substance and evaporates on firing because silver and palladium are in the alloyed state. In addition, in comparison with the fine powder obtained by means of other processes, the fine powders according to the present invention are little oxidation-weighted. Therefore, the fine powders of the present invention have lower reactivity with the dielectric substance. Due to this, the capacity of the capacitor can be expected to be levelled up.

The present invention will be explained more concretely with reference to Examples hereinafter.

## Example 1

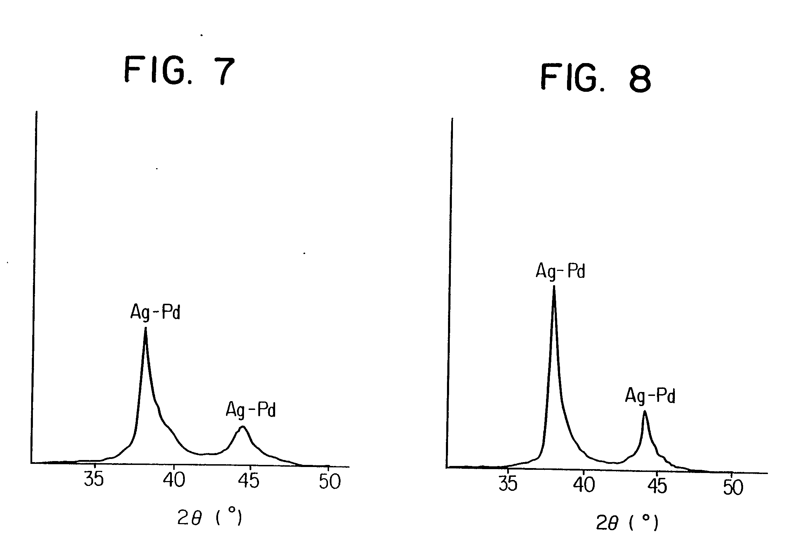

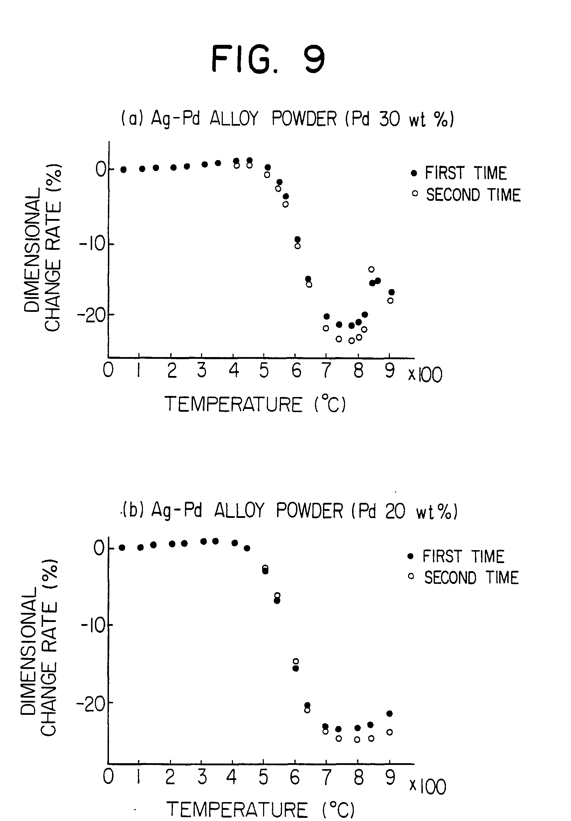

2425.7 g (10 times the theoretical amount) of hydrazine hydrate was added to 59.93 l of an acidic nitric solution (silver ion concentration: 18.69 g/l, palladium ion concentration: 8.01 g/l, temperature: 20°C) in 30 minutes, and said mixture was reacted for 40 minutes. The reduction-separated silver-palladium alloy fine powders were filtered by means of a natural gravity filter, were washed with 55 l of water, were fed with 9 l of acetone and filtered, and thereafter were dried at 70°C in a normal atmosphere, thereby obtaining 1600 g of silver-palladium alloy fine powders. The obtained silver-palladium alloy fine powder was a high purity fine powder that was composed of 70% of silver and 30% of palladium, was superior in dispersibility and had narrow particle size distribution width, an average particle diameter of 0.2 microns, a specific surface area of 19 m²/g and Na, K, Cl < 10 ppm. From its X-ray diffraction results, said silver-palladium alloy fine powder was found to indicate its peak as shown in Fig. 7. This powder, that had been heat-treated at 200°C for 10 minutes in the nitrogen atmosphere, came to be more progressively alloyed and have a specific surface area of 6.00 m²/g. The heat-treated powder was formed into a cylindrical pellet, that is 5 mm in diameter and 5 mm in height, at a pressure of 1000 Kg/cm² by means of a double pushing type forming jig. Said pellet was measured twice in respect of expansion and shrinkage up to 900°C at a temperature rise rate of 20°C/min. in air by means of an expansion coefficient meter. The obtained results are shown in Fig. 9(a). It can be seen therefrom that the expansion and contraction at 350°C—500°C, which are called into question when said pellet was used for an inner electrode in a ceramic capacitor, were scarcely observed. This powder was mixed with a glass frit, an organic binder and an organic solvent. This mixture was made into a paste. This paste was screen printed on an alumina substrate, and fired at 900°C for 10 minutes in the air. The resistivity of the obtained thick film was $3.4 \times 10^{-5}\,\Omega$ . cm.

## Example 2

139.7 g (10 times the theoretical amount) of hydrazine hydrate was added to 1 l of an acidic nitric solution (silver ion concentration: 80 g/l, palladium ion concentration: 20 g/l, temperature: 20°C) in 15 minutes, and said mixture was reacted for 30 minutes. The reduction-separated silver-palladium alloy fine powder was filtered, washed and dried in the same manner as employed in Example 1, thereby obtaining 100 g of silver-palladium alloy fine powders.

The obtained powder was a high purity fine powder that was composed of 80% of silver and 20% of palladium and had a particle diameter of 0.2 microns, a specific surface area of 9.93 m$^2$/g and Na, K, Cl < 10 ppm. From its X-ray diffraction results, said silver-palladium alloy fine powder was found to indicate peaks as shown in Fig. 8. This powder, which had been heat-treated at 200°C, came to be more progressively alloyed and have a specific surface area of 5.65 m$^2$/g. The heat-treated powder was measured twice in respect of expansion and shrinkage in the same manner as employed in Example 1.

The obtained results are shown in Fig. 9(b). The expansion and shrinkage at 350°C—500°C were scarcely observed. The resistivity of the thick film obtained by paste printing and then firing at 900°C for 10 minutes was 1.2 × 10$^{-5}$ Ω cm.

### Comparative Example 1

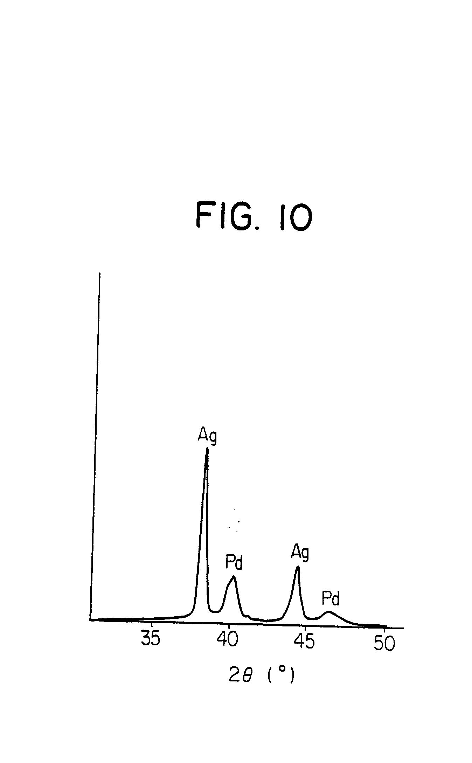

22.74 g (3 times the theoretical amount) of hydrazine hydrate was added to 1.87 l of a silver-palladium ammonium complex solution (silver ion concentration: 18.69 g/l, palladium ion concentration. 8.01 g/l, temperature: 20°C, pH: 9.0), and said mixture was reduced. The reduction-separated silver-palladium fine powders were filtered by means of a natural gravity filter, were washed with 2 l of water, and thereafter were fed with 300 ml of acetone and filtered, and thereafter were dried at 70°C in a normal atmosphere, thereby obtaining 50 g of a silver-palladium fine powder. This powder was composed of 70% of silver and 30% of palladium. It was observed from the results of X-ray diffraction that this powder was a mere mixture of silver and palladium as shown in Fig. 10, and did not display any change even after the heat-treatment at 200°C.

### Comparative Example 2

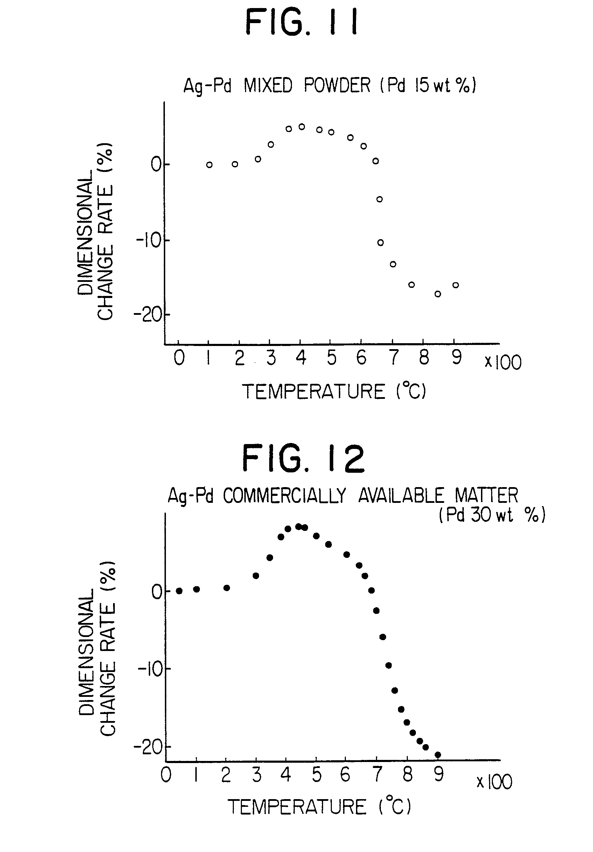

A silver-palladium mixed powder (palladium composition 15 wt.%) was obtained by well mixing silver powder (0.5 micron meter) and palladium powder (0.1 micron meter) for a long period of time. This mixed powder was measured in respect of expansion and contraction in the same manner as employed in Example 1. The obtained results are shown in Fig. 11. It can be seen therefrom that the expansion and shrinkage at 350—500°C are very violent in comparison with the alloy powder obtained according to the present invention. The results obtained by measuring the expansion and contraction of a silver-palladium powder (Pd composition 30 wt.%) extracted from a commercially available silver-palladium paste are shown in Fig. 12.

It can be seen from the results that said expansion and contraction are still very violent in comparison with the alloy powder obtained according to the present invention.

### Claims

1. A process for the production of a silver-palladium alloy in the form of a fine powder, which comprises adding hydrazine or a hydrazine compound to an acidic solution containing silver and palladium as ions, and reducing the ions; separating a silver-palladium alloy fine powder, having an average particle diameter of 0.01—1.0 μm formed by reduction; and heat-treating the alloy fine powder at a temperature of 100—500°C in an inert atmosphere or vacuum.

2. A process according to claim 1, wherein the sum total of silver and palladium is 10—200 g per litre of said solution.

3. A process according to claim 1 or claim 2, wherein the hydrazine or hydrazine compound is added in an amount 2—10 times the equivalent required for reducing the silver ions and palladium ions in the solution to metals.

4. A process according to any preceding claim, wherein the solution is maintained at 10—100°C during reduction.

5. A process according to any preceding claim, wherein the acidic solution is formed from silver nitrate, palladium nitrate and nitric acid.

### Patentansprüche

1. Verfahren für die Herstellung einer Silber-Palladium-Legierung in Form eines feines Pulvers, umfassend:

Hinzufügen von Hydrazin oder einer Hydrazin-Verbindung zu einer saure Lösung, die Silber und Palladium als Ionen enthält, und Reduzieren der Ionen;

Separieren eines feinen, durch Reduktion gebildeten Pulvers aus Silber-Palladium-Legierung, die einen mittleren Partikel-Durchmesser von 0,01—1,0 μm hat;

Wärmebehandlung des feinen Legierungspulvers bei einer Temperatur von 100—500°C in einer inerten Atmosphäre oder unter Vakuum.

2. Verfahren nach Anspruch 1, wobei der Gesamtanteil von Silber und Palladium 10—200 g pro Liter der genannten Lösung beträgt.

3. Verfahren nach Anspruch 1 oder 2, wobei das Hydrazin oder die Hydrazin-Verbindung in einer Menge hinzugefügt wird, die dem Zwei- bis Zehnfachen des Äquivalentes enspricht, das erforderlich ist, um die Silber-Ionen und Palladium-Ionen in der Lösung zu Metallen zu reduzieren.

4. Verfahren nach einem der vorhergehenden Ansprüche, wobei die Lösung bei 10—100°C während der Reduktin gehnalten wird.

5. Verfahren nach einem der vorhergehenden Ansprüche, wobei die saure Lösung aus Silbernitrat, Palladiumnitrat und Salpetersäure besteht.

## Revendications

1. Procédé pour la production d'un alliage argent-palladium sous la forme d'une poudre fine, qui consiste à ajouter de l'hydrazine ou un composé d'hydrazine à une solution acide contenant de l'argent et du palladium à l'état d'ions, et réduire les ions; à séparer une poudre fine d'alliage argent-palladium formée par réduction, ayant un diamètre moyen de particules de 0,01 à 1,0 μm; et à traiter thermiquement la poudre fine d'alliage à une température de 100 à 500°C dans une atmosphère inerte ou sous vide.

2. Procédé selon la revendication 1, dans lequel la somme totale d'argent et de palladium est de 10 à 200 g par litre de ladite solution.

3. Procédé selon la revendication 1 ou la revendication 2, dans lequel l'hydrazine ou le composé d'hydrazine est ajouté en une quantité de 2 à 10 fois l'équivalent nécessaire pour réduire en métaux les ions argent et les ions palladium contenus dans la solution.

4. Procédé selon l'une quelconque des revendications précédentes, dans lequel la solution est maintenue entre 10 et 100°C pendant la réduction.

5. Procédé selon l'une quelconque des revendications précédentes, dans lequel la solution acide est formée à partir de nitrate d'argent, de nitrate de palladium et d'acide nitrique.

EP 0 249 366 B1

# FIG. I

Ag

Pd

Ag

Pd

35        40        45        50

$2\theta$ (°)

# FIG. 2

Ag

Pd

Ag

Pd

35        40        45        50

$2\theta$ (°)

# FIG. 3

# FIG. 4

Ag-Pd

Pd

Ag-Pd

Pd

$2\theta$ (°)

Ag-Pd

Ag-Pd

$2\theta$ (°)

EP 0 249 366 B1

# FIG. 6

Ag-Pd

Ag-Pd

2θ (°)

35   40   45   50

# FIG. 5

Ag-Pd

Ag-Pd

2θ (°)

35   40   45   50

# FIG. 7

Ag-Pd

Ag-Pd

35    40    45    50

$2\theta$ ( °)

# FIG. 8

Ag-Pd

Ag-Pd

35    40    45    50

$2\theta$ ( °)

EP 0 249 366 B1

# FIG. 9

(a) Ag-Pd ALLOY POWDER (Pd 30 wt %)

- FIRST TIME
- SECOND TIME

(b) Ag-Pd ALLOY POWDER (Pd 20 wt%)

- FIRST TIME
- SECOND TIME

5

# FIG. 10

# FIG. 11

Ag-Pd MIXED POWDER (Pd 15 wt %)

# FIG. 12

Ag-Pd COMMERCIALLY AVAILABLE MATTER
(Pd 30 wt %)